# EUROPÄISCHE PATENTANMELDUNG

(11) **EP 1 249 868 A1**
(43) Veröffentlichungstag der Anmeldung: **16.10.2002**
(21) Anmeldenummer: 01810365.5
(22) Anmeldetag: 12.04.2001
(51) Int. Cl.: H01L 23/367, H01L 23/473

(54) **Kühlungseinrichtung für ein elektronisches Bauelement sowie Kühlsystem mit solchen Kühlungseinrichtungen**

(71) Anmelder: ABB Schweiz AG, 5400 Baden (CH)
(72) Erfinder: Werninger, Johannes, 8008 Zürich (CH)
(74) Vertreter: ABB Patent Attorneys

(57) **Zusammenfassung**

Es wird eine Kühlungseinrichtung für ein elektronisches Bauelement angegeben, die aus einem Stapel (1) aufeinanderliegender und miteinander verbundener Profilplatten (2a;2b) aufgebaut ist und am Stapelabschluss Abschlussplatten (3) in Stapelrichtung (x) vorgesehen sind, wobei mindestens eine der Abschlussplatten (3) zur flächigen Kontaktierung des elektrischen Bauelements ausgebildet. Desweiteren weist mindestens eine der Profilplatten (2a) einen flexiblen Fortsatz (4) auf, wobei der Fortsatz (4) über den Querschnitt des Stapels (1) hinausragt. Darüber hinaus ist ein Kühlsystem mit mindestens zwei solcher Kühleinrichtungen offenbart.

## Beschreibung

### Technisches Gebiet

Die vorliegende Erfindung bezieht sich auf das Gebiet der Kühltechnik und Stromleitertechnik. Sie betrifft eine Kühlungseinrichtung für ein elektronisches Bauelement und ein Kühlsystem mit solchen Kühlungseinrichtungen gemäss dem Oberbegriff der unabhängigen Ansprüche.

### Stand der Technik

Kühlungseinrichtungen für elektronische Bauelemente, insbesondere für Leistungshalbleitermodule werden heute in einer Fülle von leistungselektronischen Schaltungen eingesetzt. Gängigerweise dient ein Kühlfluid, welches durch die Kühlungseinrichtung strömt, der Abfuhr überschüssiger Wärmeenergie des zu kühlenden elektronischen Bauelements.

In der WO 00/21131 ist eine für die Kühlung eines elektronischen Bauelementes geeignete Kühlungseinrichtung offenbart. Darin ist die Kühlungseinrichtung aus gestapelten und aufeinanderliegenden Profilplatten aufgebaut, wobei die Profilplatten miteinander verbunden sind. Das Profil der Profilplatten ist derart ausgestaltet, dass durch das Stapeln der Profilplatten im Stapel Kühlkanäle ausgebildet sind. Zur Zuführung eines Kühlfluids sind senkrecht zur Stapelrichtung Kühlfluidanschlüsse angeordnet, die sich in einen Teil der Kühlkanäle erstrecken.

Desweiteren ist der Stapel der Profilplatten der Kühlungseinrichtung aus der WO 00/21131 mit Abschlussplatten in Stapelrichtung abgeschlossen. Eine der Abschlussplatten ist als Montageplatte ausgeführt. Diese Montageplatte dient der flächigen Kontaktierung des zu kühlenden elektronischen Bauelements zur Wärmeabfuhr an die Kühlungseinrichtung. Darüber hinaus ermöglicht die flächige Kontaktierung eine elektrische Verbindung, insbesondere zur Stromführung zum oder vom zu kühlenden elektronischen Bauelement. Die elektrische Verbindung von der Montageplatte zu einer Stromverschienung erfolgt über eine Schraubenverbindung.

Problematisch bei einer Kühlungseinrichtung nach der WO 00/21131 ist, dass die elektrische Verbindung mittels der Schraubenverbindung zwischen Montageplatte und der Stromverschienung eine hochinduktive Bauweise darstellt, wodurch bei grossen Stromänderungen hohe Spannungen induziert werden, welche das zu kühlende elektronische Bauelement zerstören können. Weiterhin werden auftretende mechanische Einwirkungen auf die Stromverschienung an die über die Schraubenverbindung verbundene Montageplatte nahezu ungedämpft weitergeleitet, so dass das elektronische Bauelement beschädigt werden kann oder von der Montageplatte abreisst. Darüber hinaus weist die Schraubenverbindung einen hohen Kontaktübergangswiderstand auf, der grosse elektrische Verluste bedingt. Desweiteren ist eine solche Schraubenverbindung montageintensiv und benötigt entsprechend viel Platz für die Montage und für die Zugänglichkeit für Kontrollzwecke, so dass zudem hohe Kosten entstehen.

Ferner ist in der WO 00/21131 ein Kühlsystem angegeben, welches zwei Kühlungseinrichtungen aufweist. Eine erste Kühlungseinrichtungen ist einerseits mit ihrer Montageplatte mittels Schraubenverbindung mit einer Stromverschienung verbunden, so dass eine elektrischen Verbindung entsteht. Andererseits ist die erste Kühlungseinrichtung ebenfalls mit einer Schraubenverbindung mit dem zu kühlenden elektrischen Bauelement verbunden. Eine zweite Kühlungseinrichtung ist mit der ersten Kühlungseinrichtung über das zu kühlende Bauelement und einer Zwischenverschienung sowohl thermisch als auch elektrisch leitend verbunden. Dazu ist die zweite Kühlungseinrichtung mittels einer Kraftbeaufschlagung gegen die Zwischenverschienung gepresst. Die Kraftbeaufschlagung bewirkt weiterhin, dass die Zwischenverschienung gegen das zu kühlende elektrischen Bauelement gepresst wird.

Das vorstehend beschriebene Kühlsystem der WO 00/21131 ist besonders anfällig gegen mechanische Schwingungen, die ein Verrutschen und/oder Brechen der zweiten Kühlungseinrichtung und/oder der Zwischenverschienung bewirken kann. Dadurch kann aber für eine ausreichende Wärmeabfuhr zu gewährleistende thermische Kontaktierung der zweiten Kühlungseinrichtung mit dem zu kühlenden elektronischen Bauelement über die Zwischenverschienung nicht mehr erreicht werden. Desweiteren ist die elektrische Kontaktierung zwischen den beiden Kühlungseinrichtungen über das zu kühlende elektronische Bauelement und der Zwischenverschienung durch das vorstehend erwähnte Verrutschen nicht mehr gewährleistet. Dies kann zu Teilentladungen führen, wodurch das elektronische Bauelement zerstört werden kann.

### Darstellung der Erfindung

Aufgabe der Erfindung ist es deshalb, eine Kühlungseinrichtung für ein elektronisches Bauelement auszubilden, die sich durch eine niederinduktive und gleichzeitig in Bezug auf mechanische Einwirkungen flexible Verbindungsmöglichkeit auszeichnet und einen montagefreundlichen sowie platzsparenden und damit kostengünstigen Aufbau aufweist. Ferner ist ein Kühlsystem anzugeben, welches die erfindungsgemässen Kühlungseinrichtungen umfasst und einen robusten und schwingungsfesten Aufbau gegenüber mechanischen Einwirkungen aufweist. Diese Aufgaben werden durch die Merkmale des Anspruchs 1 und 12 gelöst. In den Unteransprüchen sind vorteilhafte Weiterbildungen der Erfindung angegeben.

Die erfindungsgemässe Kühlungseinrichtung für ein elektronisches Bauelement ist aus einem Stapel aufeinanderliegender und miteinander verbundener Profilplatten aufgebaut. Am Stapelabschluss sind Abschlussplatten in Stapelrichtung vorgesehen, wobei mindestens eine der Abschlussplatten zur flächigen sowohl thermischen als auch elektrischen Kontaktierung des elektrischen Bauelements ausgebildet ist. Erfindungsgemäss weist mindestens eine der Profilplatten einen flexiblen Fortsatz auf, der über den Querschnitt des Stapels hinausragt. Durch diesen flexiblen Fortsatz wird eine besonders niederinduktive Verbindungsmöglichkeit beispielsweise zu einer Stromverschienung geschaffen, so dass die Gefahr der Zerstörung des zu kühlenden elektronischen Bauelementes infolge von hohen induzierten Spannungen minimiert werden kann. Mit Hilfe des flexiblen Fortsatzes werden zudem vorteilhaft mechanische Einwirkungen, insbesondere Rüttelbewegungen oder mechanische Schwingungen von der Kontaktierung des zu kühlenden Bauelementes auf der Abschlussplatte und damit vom Bauelement selbst ferngehalten, so dass selbst starke mechanische Einwirkungen auf den flexiblen Fortsatz nahezu keine mechanische Wirkung auf den Stapel der Profilplatten, auf die Abschlussplatten und auf das Bauelement haben. Die erfindungsgemäss Kühlungseinrichtung ist ferner sehr einfach, platzsparend und montagefreundlich, insbesondere bei Austausch des elektronischen Bauelementes aufgebaut, da keine wie aus dem Stand der Technik bekannte montage- und wartungsintensive Schraubenverbindungen vorhanden sind, so dass zudem ein kostengünstiger Aufbau erzielt wird.

Beim erfindungsgemässe Kühlsystem ist mindestens ein flexibler Fortsatz einer ersten Kühlungseinrichtung mit mindestens einer zweiten Kühlungseinrichtung verbunden ist. Durch diese Verbindung wird ein besonders robuster Aufbau des erfindungsgemässen Kühlsystems erzielt, der sich vor allem gegenüber mechanischen Einwirkungen auszeichnet. Dadurch werden solche Einwirkungen weitestgehend vom jeweiligen zu jeder Kühlungseinrichtung zugehörigen elektronischen Bauelement ferngehalten, so dass auch bei extremen mechanischen Einwirkungen eine thermische und elektrischen Kontaktierung des jeweiligen elektronischen Bauelementes auf der zugehörigen Abschlussplatte gewährleistet werden kann.

Diese und weitere Aufgaben, Vorteile und Merkmale der vorliegenden Erfindung werden aus der nachfolgenden detaillierten Beschreibung bevorzugter Ausführungsbeispiele der Erfindung in Verbindung mit der Zeichnung offensichtlich.

### Kurze Beschreibung der Zeichnung

Es zeigen:
- Fig. 1: eine räumliche Darstellung einer ersten Ausführungsform einer erfindungsgemässen Kühlungseinrichtung für ein elektronisches Bauelement,
- Fig. 2: eine räumliche Darstellung einer zweiten Ausführungsform der erfindungsgemässen Kühlungseinrichtung für ein elektronisches Bauelement,
- Fig. 3: eine Schnittdarstellung der zweiten Ausführungsform der erfindungsgemässen Kühlungseinrichtung für ein elektronisches Bauelement und
- Fig.4: eine räumliche Darstellung eines erfindungsgemässen Kühlsystems.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

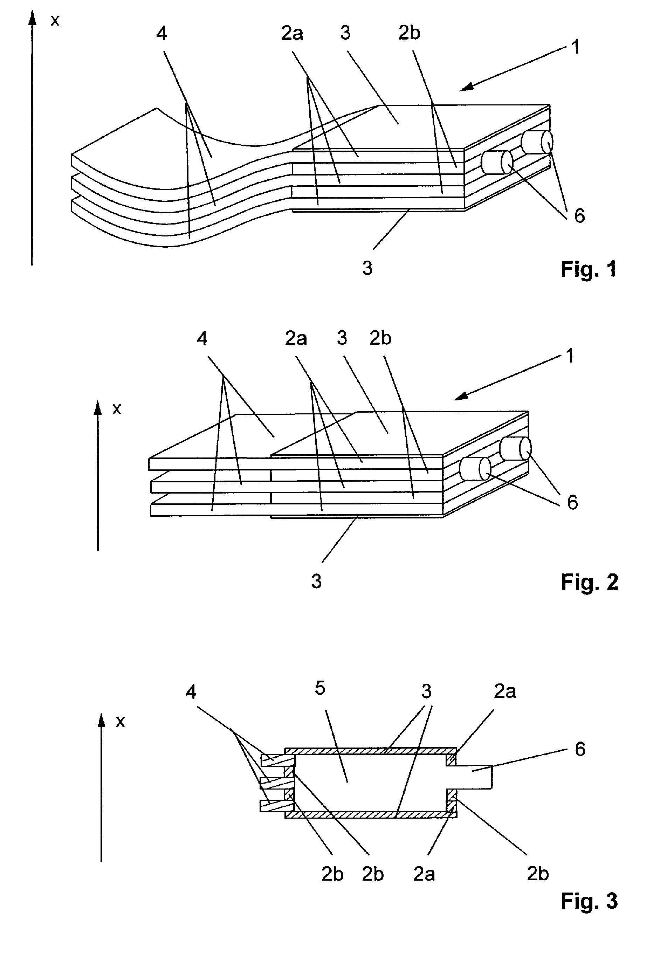

In Fig. 1 ist eine räumliche Darstellung einer ersten Ausführungsform einer erfindungsgemässen Kühlungseinrichtung für ein elektronisches Bauelement gezeigt. Die Kühlungseinrichtung ist aus einem Stapel 1 aufeinanderliegender Profilplatten 2a, 2b aufgebaut, wobei die Profilplatten 2a, 2b miteinander verbunden sind, vorzugsweise im Randbereich des Querschnitts des Stapels 1. Vorzugsweise ist dieses Verbindung zwischen den Profilplatten 2a, 2b eine Schweissverbindung oder eine Verbindung, welche durch Wärmeeinfluss und gleichzeitiger Druckeinwirkung in Stapelrichtung x ein Verbacken der Profilplatten 2a, 2b miteinander bewirkt. Gemäss Fig. 1 sind am Stapelabschluss Abschlussplatten 3 in Stapelrichtung x vorgesehen. Gemäss Fig. 1 ist jeweils eine Abschlussplatte 3 am Stapelabschluss in Stapelrichtung mit jeweils einer Profilplatte 2a, 2b in derselben Weise verbunden, wie die vorstehend beschriebene Verbindung der Profilplatten 2a, 2b miteinander. Mindestens eine der Abschlussplatten 3 ist derart ausgebildet, dass ein zu kühlendes elektronisches Bauelement flächig sowohl elektrisch als auch thermisch kontaktierbar ist. Der Übersichtlichkeit halber ist aber ein solches elektronisches Bauelement in Fig. 1 nicht dargestellt. Die Profilplatten 2a, 2b und die Abschlussplatten 3 sind aus einem elektrisch leitfähigen Material aufgebaut, wodurch die gewünschte elektrische und thermische Kontaktierung des zu kühlenden elektronischen Bauelementes erreicht wird und die Kühlungseinrichtung selbst elektrisch leitfähig ist. Vorteilhaft wird als leitfähiges Material Aluminium gewählt, so dass Gewicht und Kosten eingespart werden können.

Erfindungsgemäss weist mindestens eine der Profilplatten 2a einen flexiblen Fortsatz 4 auf, der über den Querschnitt des Stapels 1 hinausragt. Durch diesen flexiblen Fortsatz 4 wird eine besonders niederinduktive Verbindungsmöglichkeit beispielsweise zu einer Stromverschienung erreicht, so dass hohe induzierte Spannungen reduziert oder vermieden werden können und damit die Gefahr der Zerstörung des zu kühlenden elektronischen Bauelementes minimiert werden kann. Weiterhin ist die erfindungsgemässe Kühlungseinrichtung gemäss Fig. 1 sehr montagefreundlich, platzsparend und somit kostengünstig aufgebaut, da keine wie aus dem Stand der Technik bekannte Schraubenverbindungen beispielsweise mit einer Stromverschienung eingesetzt werden. Darüber hinaus werden mittels des flexiblen Fortsatzes 4 vorteilhaft mechanische Einwirkungen, insbesondere Rüttelbewegungen oder mechanische Schwingungen von der Kontaktierung des Bauelementes auf der Abschlussplatte 3 und damit vom Bauelement selbst ferngehalten, da der flexible Fortsatz 4 diese Einwirkungen aufnimmt, diese jedoch nur in geringem Masse an den Stapel 1 der Profilplatten 2a, 2b, an die Abschlussplatten 3 und an das Bauelement überträgt.

Der flexible Fortsatz 4 verläuft gemäss Fig. 1 vorteilhaft im wesentlichen schräg zur Stapelrichtung x der Profilplatten 2a, 2b. Dadurch kann eine weitere Verbesserung des Fernhaltens von mechanischen Einwirkungen auf den Stapel 1, auf die Abschlussplatten 3 und auf das Bauelement erreicht werden, da durch den schrägen Verlauf des flexiblen Fortsatzes 4 bezüglich der Stapelrichtung x eine genügend grosse Ausweichamplitude des flexiblen Fortsatzes 4 zur Aufnahme grosser Amplituden mechanischer Einwirkungen auf den flexiblen Fortsatz 4 zur Verfügung steht. Weiterhin wird ein montagefreundlicher Aufbau erreicht, wodurch sich das zu kühlende elektronische Bauelement beispielsweise sehr einfach und schnell austauschen lässt.

Eine räumliche Darstellung einer zweiten Ausführungsform der erfindungsgemässen Kühlungseinrichtung für ein elektronisches Bauelement ist in Fig. 2 gezeigt. Die in Fig. 2 dargestellte Ausführungsform der Kühlungseinrichtung unterscheidet sich von der in Fig. 1 gezeigten Ausführungsform der Kühlungseinrichtung dadurch, dass der flexible Fortsatz 4 im wesentlichen senkrecht zur Stapelrichtung x verläuft. Durch diesen Verlauf des flexiblen Fortsatzes 4 wird eine sehr kurze Verbindung beispielsweise zu einer Stromverschienung, erzielt, die wenig Material benötigt.

In Fig. 1 und Fig. 2 sind mehrere Profilplatten 2a mit jeweils einem flexiblen Fortsatz 4 vorgesehen, wobei die flexiblen Fortsätze 4 vorzugsweise im wesentlichen parallel verlaufen. Dadurch kann vorteilhaft weiteres Material eingespart werden. Zudem vereinfacht sich der Herstellungsprozess der Profilplatten 2a mit jeweils einem flexiblen Fortsatz 4, da nur im wesentlichen gleichartig geformte Profilplatten 2a mit jeweils einem flexiblen Fortsatz 4 hergestellt werden müssen. Desweiteren ist gemäss Fig. 1 und Fig.2 erfindungsgemäss jeder Profilplatte 2a mit flexiblem Fortsatz 4 mindestens eine Profilplatte 2b ohne Fortsatz 4 benachbart. Mittels dieser Anordnung der Profilplatten 2a, 2b wird erreicht, dass die Oberfläche der Kühlungseinrichtung vergrössert wird und beispielsweise Luft zwischen den flexiblen Fortsätzen 4 zirkulieren kann, wodurch eine Verbesserung der Kühlleistung der Kühlungseinrichtung erzielt werden kann. Eine weitere Verbesserung der Kühlleistung und eine Materialeinsparung wird dadurch erzielt, dass keine, wie aus dem Stand der Technik bekannte Schraubenverbindungen beispielsweise zu einer Stromverschienung eingesetzt werden, sondern dass die Profilplatten 2a mit den zugehörigen flexiblen Fortsätzen 4 jeweils einstückig ausgeführt sind und damit einen durchgehenden Wärmeübergang darstellen.

In Fig. 3 ist eine Schnittdarstellung in Stapelrichtung x der zweiten Ausführungsform der erfindungsgemässen Kühlungseinrichtung gemäss Fig. 2 gezeigt. Die Profilplatten 2a, 2b sind gemäss Fig. 3 vorteilhaft als Bleche ausgebildet, so dass die gewünschte Flexibilität des flexiblen Fortsatzes 4 auf besonders einfache Weise erreicht werden kann. Ferner lässt sich die Oberfläche der Kühlungseinrichtung durch einen aus solchen als Bleche ausgebildete Profilplatten 2a, 2b aufgebauten Stapel weiter vergrössern und damit die Kühlleistung der Kühlungseinrichtung erheblich verbessern. Vorzugsweise sind die Profilplatten 2a, 2b, wie bereits vorstehend erwähnt, im Randbereich des Querschnitts des Stapels miteinander verbunden. Jede Profilplatte 2a, 2b weist ein im wesentlichen rahmenförmiges Profil auf, wie dies insbesondere in Fig. 3 gezeigt ist. Der Stapel 1 solcher Profilplatten 2a, 2b bildet mindestens einen Hohlraum 5, in dem ein Kühlfluid zirkulieren kann. Zur Zuführung und Abführung des Kühlfluids sind senkrecht zur Stapelrichtung x Kühlfluidanschlussöffnungen 6 vorgesehen, die als Durchführungen von ausserhalb des Stapels in den Hohlraum 5 ausgebildet sind. Dadurch kann das Kühlfluid besonders einfach zu- bzw. abgeführt werden.

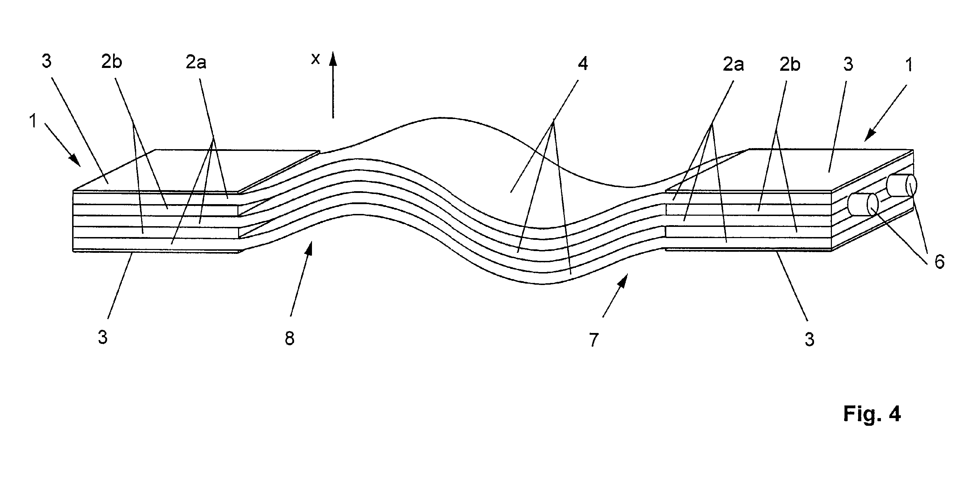

In Fig. 4 ist eine räumliche Darstellung eines erfindungsgemässen Kühlsystems gezeigt, welches aus erfindungsgemässen Kühlungseinrichtungen aufgebaut ist. Das erfindungsgemässe Kühlsystem weist mindestens zwei Kühlungseinrichtungen 7, 8 auf, wobei mindestens ein flexibler Fortsatz 4 einer ersten Kühlungseinrichtung 7 mit mindestens einer zweiten Kühlungseinrichtung 8 verbunden ist. Dadurch können mehrere elektronische Bauelemente gekühlt werden, wobei zudem eine elektrische Verbindung zwischen den einzelnen elektronischen Bauelementen und/oder zwischen den elektronischen Bauelementen und beispielsweise einer Stromverschienung ermöglicht wird. Gemäss Fig. 4 ist die erste Kühlungseinrichtung 7 mit ihren flexiblen Fortsätzen 4 vorzugsweise mit den flexiblen Fortsätzen 4 der zweiten Kühlungseinrichtung 8 verbunden, so dass vorteilhaft eine elektrisch und thermisch leitfähige Verbindung zwischen den beiden Kühlungseinrichtungen 7, 8 entsteht. Die Vorteile des erfindungsgemässen Kühlsystems liegen darüber hinaus in seinem niederinduktiven Aufbau und im Fernhalten von mechanischen Einwirkungen durch die miteinander verbunden flexiblen Fortsätze 4 der einzelnen Kühlungseinrichtungen 7, 8 von den Kontaktierungen der elektronischen Bauelemente auf den jeweiligen Abschlussplatten 3 und damit von den elektronischen Bauelementen selbst. Weiterhin kann vorteilhaft die Kühlleistung für die einzelnen elektronischen Bauelemente durch eine grosse Oberfläche des Kühlsystems verbessert werden.

Insgesamt stellen die erfindungsgemässe Kühlungseinrichtung und das erfindungsgemässe Kühlsystem eine besonders einfache und damit kostengünstige und zuverlässig Lösung dar, die sich vor allem durch ihre niederinduktiven Aufbauten und durch ihre vorstehend beschriebenen positiven Eigenschaften auf mechanische Einwirkungen auszeichnet.

### Bezugszeichenliste

- 1: Stapel
- 2a; 2b: Profilplatte
- 3: Abschlussplatte
- 4: Fortsatz
- 5: Holraum
- 6: Kühlfluidanschlussöffnungen
- 7: erste Kühlungseinrichtung
- 8: zweite Kühlungseinrichtung

## Patentansprüche

1. Kühlungseinrichtung für ein elektronisches Bauelement, die aus einem Stapel (1) aufeinanderliegender und miteinander verbundener Profilplatten (2a;2b) aufgebaut ist und am Stapelabschluss Abschlussplatten (3) in Stapelrichtung (x) vorgesehen sind, wobei mindestens eine der Abschlussplatten (3) zur flächigen Kontaktierung des elektrischen Bauelements ausgebildet ist, durch **gekennzeichnet**,
dass mindestens eine der Profilplatten (2a) einen flexiblen Fortsatz (4) aufweist und der Fortsatz (4) über den Querschnitt des Stapels (1) hinausragt.

2. Kühlungseinrichtung nach Anspruch 1, **dadurch gekennzeichnet, dass** die Profilplatten (2a; 2b) als Bleche ausgebildet sind.

3. Kühlungseinrichtung nach Anspruch 1 oder 2, **dadurch gekennzeichnet, dass** der Fortsatz (4) im wesentlichen senkrecht zur Stapelrichtung (x) verläuft.

4. Kühlungseinrichtung nach Anspruch 1 oder 2, **dadurch gekennzeichnet, dass** der Fortsatz (4) im wesentlichen schräg zur Stapelrichtung (x) verläuft.

5. Kühlungseinrichtung nach einem der vorhergehenden Ansprüche, **dadurch gekennzeichnet, dass** die Profilplatten (2a; 2b) aus einem elektrisch leitfähigen Material aufgebaut sind.

6. Kühlungseinrichtung nach Anspruch 5, **dadurch gekennzeichnet, dass** als leitfähiges Material Aluminium gewählt ist.

7. Kühlungseinrichtung nach einem der vorhergehenden Ansprüche, **dadurch gekennzeichnet, dass** bei mehreren Profilplatten (2a) mit jeweils einem Fortsatz (4) die Fortsätze im wesentlichen parallel verlaufen.

8. Kühlungseinrichtung nach einem der vorhergehenden Ansprüche, **dadurch gekennzeichnet, dass** jeder Profilplatte (2a) mit Fortsatz (4) mindestens eine Profilplatte (2b) ohne Fortsatz (4) benachbart ist.

9. Kühlungseinrichtung nach einem der vorhergehenden Ansprüche, **dadurch gekennzeichnet, dass** jede Profilplatte (2a; 2b) ein im wesentlichen rahmenförmiges Profil aufweist.

10. Kühlungseinrichtung nach Anspruch 9, **dadurch gekennzeichnet, dass** die gestapelten Profilplatten (2a; 2b) mindestens einen Hohlraum (5) im Innern des Stapels bilden.

11. Kühlungseinrichtung nach Anspruch 10, **dadurch gekennzeichnet, dass** senkrecht zur Stapelrichtung Kühlfluidanschlussöffnungen (6) vorgesehen sind, die als Durchführungen von ausserhalb des Stapels (1) in den Holraum (5) ausgebildet sind

12. Kühlsystem mit mindestens zwei Kühlungseinrichtungen (7; 8) nach einem der Ansprüche 1 bis 11, **dadurch gekennzeichnet, dass** mindestens ein Fortsatz (4) einer ersten Kühlungseinrichtung (7) mit mindestens einer zweiten Kühlungseinrichtung (8) verbunden ist.
